Europäisches Patentamt

European Patent Office

Office européen des brevets

(11) Veröffentlichungsnummer: **0 446 998 A2**

## (12) EUROPÄISCHE PATENTANMELDUNG

(21) Anmeldenummer: **91200533.7**

(22) Anmeldetag: **12.03.91**

(51) Int. Cl.5: **G01R 33/34**

(30) Priorität: **15.03.90 DE 4008202**

(43) Veröffentlichungstag der Anmeldung:
**18.09.91 Patentblatt 91/38**

(84) Benannte Vertragsstaaten:
**CH DE FR GB IT LI NL SE**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**

**Groenewoudseweg 1**
**NL-5621 BA Eindhoven(NL)**

(84) **CH FR GB IT LI NL SE**

(72) Erfinder: **Röschmann, Peter Karl Hermann**
**Steenbalken 13**
**W-2000 Hamburg 63(DE)**

(74) Vertreter: **Koch, Ingo, Dr.-Ing. et al**
**Philips Patentverwaltung GmbH**
**Wendenstrasse 35 Postfach 10 51 49**
**W-2000 Hamburg 1(DE)**

(54) **Kernspinuntersuchungsgerät.**

(57) Kernspinuntersuchungsgerät mit einem Magnetsystem (31,32) zum Erzeugen eines stationären Magnetfeldes in einem Untersuchungsraum (2), mit einer Sendeeinrichtung (12,13,18,28) zur Erzeugung eines dem stationären Magnetfeld in einem Untersuchungsobjekt (30) zu überlagernden Hochfrequenzfeldes, mit Mitteln zur Resonanzüberhöhung des im Untersuchungsobjekt (30) wirksamen Hochfrequenzfeldes und mit einer Einrichtung zur Detektierung von im Untersuchungsobjekt (30) erzeugten Magnetresoananzsignalen. Mit einfachen Mitteln sind dadurch höhere $B_1$-Felder erzielbar, daß mindestens ein dem Untersuchungsobjekt (24) benachbarter dielektrischer Resonator (1,5,10,16,17,20,21) vorgesehen ist, welcher aus einem Dielektrikum mit einer relativen Dielektrizitätszahl $\epsilon_r > 20$ besteht und dessen Abmessungen derart gewählt sind, daß in ihm mittels einer benachbarten Sendeeinrichtung (12,13,18) mindestens eine Resonanzmode mit einer Frequenz antegbar ist, die im Bereich der zu detektierenden Larmorfrequenzen der im Untersuchungsobjekt (24) anzuregenden Kerne, insbesondere Protonen liegt.

FIG.1

EP 0 446 998 A2

Die Erfindung bezieht sich auf ein Kernspinuntersuchungsgerät mit einem Magnetsystem zum Erzeugen eines stationären Magnetfeldes in einem Untersuchungsraum, mit einer Sendeeinrichtung zur Erzeugung eines dem stationären Magnetfeld in einem Untersuchungsobjekt zu überlagernden Hochfrequenzfeldes, mit Mitteln zur Resonanzüberhöhung des im Untersuchungsobjekt wirksamen Hochfrequenzfeldes und mit einer Einrichtung zur Detektierung von im Untersuchungsobjekt erzeugten Magnetresonanzsignalen.

Derartige Anordnungen werden insbesondere auf dem Gebiet der medizinischen Diagnostik für Kernspintomographiegeräte benötigt. Im in der Grundform zylindrischen zentralen Untersuchungsraum solcher Geräte wird ein homogenes magnetisches Gleichfeld ($B_0$-Feld) erzeugt, welchem Gradientenfelder überlagert werden. Die Feldlinien des $B_0$-Feldes verlaufen in Richtung der Zylinderachse des Untersuchungsraumes, welche als z-Achse bezeichnet wird. Dem $B_0$-Feld überlagerte stationäre und/oder gepulste Gradientenfelder bewirken ein gezieltes Gefälle der Gleichfeldverteilung in mindestens einer der Koordinatenrichtungen x,y,z.

In einem Untersuchungsobjekt muß ein senkrecht zum $B_0$-Feld gerichtetes möglichst homogenes Hochfrequenzfeld ($B_1$-Feld) mit einer Frequenz erzeugt werden, die der Larmorfrequenz der im $B_0$-Feld ausgerichteten Kerne gleich ist. Die Larmor-(Kreis)frequenz, mit welcher die Spinachse der Kerne um die Richtung des Magnetfeldes präzediert, ergibt sich als Produkt eines kernspezifischen gyromagnetischen Faktors und der magnetischen Feldstärke $B_0$. Der gyromagnetische Faktor hängt vom Aufbau des Kerns ab. Für die Protonen des Wasserstoffisotops $^1H$ ergibt sich z.B. bei $B_0 = 4$ Tesla eine Larmorfrequenz von etwa 170 MHz. Bei der MR-Tomographie (MR = Magnetresonanz) zur Untersuchung von Patienten sind insbesondere die von $^1H$-Protonen infolge des $B_1$-Feldes gebildeten und zu detektierenden MR-Signale bedeutsam, jedoch können für spektroskopische Untersuchungen auch die Signale anderer und verschiedener Kerne ausgewertet werden.

Eine Anordnung der eingangs genannten Art ist beispielsweise durch die DE-OS 34 10 204 bekannt. Bei dort verwendeten HF-Spulen und Resonatoren mit leitergebundenen HF-Strömen liegt das Maximum des $B_1$-Feldes auf den Leiteroberflächen, während im für die Einbringung eines Untersuchungsobjekts verfügbaren Nutzraum innerhalb einer sogenannten Körperspule eine erheblich geringere Feldintensität vorhanden ist. Auch bei an einen Untersuchungskörper zu legenden sogenannten Oberflächenspulen nimmt die Intensität des $B_1$-Feldes zum Inneren des Untersuchungsobjekts hin sehr schnell ab.

Das Signal zu Rauschverhältnis wird für die zu detektierenden MR-Signale mit zunehmender Intensität des im Untersuchungsobjekt erzeugten $B_1$-Feldes günstiger.

Der Erfindung liegt die Aufgabe zugrunde, eine Anordnung der eingangs genannten Art derart zu gestalten, daß im Untersuchungsobjekt mit einfachen Mitteln höhere $B_1$-Felder erzielbar sind.

Die Lösung gelingt dadurch, daß mindestens ein dem Untersuchungsobjekt benachbarter dielektrischer Resonator vorgesehen ist, welcher aus einem Dielektrikum mit einer relativen Dielektrizitätszahl $\epsilon > 20$ besteht und dessen Abmessungen derart gewählt sind, daß in ihm mittels einer benachbarten Sendeeinrichtung mindestens eine Resonanzmode mit einer Frequenz anregbar ist, die im Bereich der zu detektierenden Larmorfrequenzen der im Untersuchungsobjekt anzuregenden Kerne, insbesondere Protonen liegt.

Durch die Erfindung ergeben sich insbesondere die Vorteile, daß das Signal zu Rauschverhältnis bei der Detektion der MR-Signale erheblich verbessert wird und daß erheblich geringere Sendeleistungen zur Anregung der gewünschten Resonanzfelder erforderlich sind.

Dielektrische Resonatoren sind elektrisch nicht leitende Körper, deren Dielektrizitätszahl $\epsilon_r$ größer als die des umgebenen Mediums ist. Insbesondere sind zur Bildung solcher dielektrischer Resonatoren isolierende Stoffe mit besonders hoher Dielektrizitätszahl geeignet. In einem dielektrischen Resonator entstehen bei Anregung mit einem magnetischen HF-Feld geeigneter Frequenz stehende Wellen. Innerhalb des dielektrischen Resonators ergeben sich charakteristische Verteilungen der magnetischen und der elektrischen Feldstärke, welche als Moden bezeichnet werden. Dabei ergibt sich innerhalb des dielektrischen Resonators mindestens ein Bereich maximaler magnetischer Feldstärke, wobei in diesem Bereich die elektrische Feldstärke eine Nullstelle und somit einen diese Nullstelle umgebenden Nullbereich mit sehr geringer Feldstärke aufweist.

Bei Moden der niedrigsten Ordnungszahlen (Grundmoden) ergibt sich in der Mitte des dielektrischen Resonators ein einziger Maximalbereich der magnetischen Feldstärke, jedoch können auch Moden höherer Ordnung angeregt werden, welche z.B. zwei Maximalbereiche der magnetischen Feldstärke innerhalb des dielektrischen Resonators aufweisen. Einzelheiten über Form und Entstehungsbedingungen von Moden in dielektrischen Körpern sind in der Druckschrift IEEE Transactions on Microwave Theory and Techniques, 1984, Seiten 1609 bis 1616 und den dort angezogenen Literaturstellen erläutert. Besonders geeignete Körperformen für dielektrische Resonatoren sind kugelförmige, zylindrische oder ellipsoide Gebilde, also elementare regelmäßige Körper.

Mittels eines erfindungsgemäß vorzusehenden dielektrischen Resonators können in einem Untersuchungsobjekt, insbesondere in Körperteilen eines Patienten, besonders hohe $B_1$-Felder erzeugt werden, deren Feldstärke insbesondere im Inneren des Untersuchungsobjekts erheblich höhere Werte aufweist, als es mit herkömmlichen leitergebundenen Resonatoren erreichbar ist.

Eine Ausführungsform der Erfindung ist dadurch gekennzeichnet, daß im dielektrischen Resonator eine zentrale Ausnehmung im Nullbereich der elektrischen Feldstärke der anregbaren Resonanzmode angeordnet ist. In der Ausnehmung für die Einführung eines Untersuchungsobjekts bleibt die magnetische Feldstärke gegenüber einem nicht mit einer Ausnehmung versehenen dielektrischen Resonator praktisch unverändert auf maximaler Höhe. Da nämlich die elektrische Feldstärke im Bereich der Ausnehmung eine Nullstelle und in deren Umgebung auch sehr niedrige Werte aufweist, wird trotz der in der Ausnehmung erheblichen erniedrigten Dielektrizitätszahl keine nennenswerte Veränderung der magnetischen Feldverteilung bewirkt.

Wenn der dielektrische Resonator derart bemessen ist, daß eine Resonanzmode mit zwei Nullbereichen der elektrischen Feldstärke anregbar ist und in den Nullbereichen jeweils eine Ausnehmung zur Einführung von Untersuchungsobjekten vorgesehen ist, können zwei Körperteile gleichzeitig untersucht werden.

Eine besonders vorteilhafte Ausführungsart der Erfindung ist dadurch gekennzeichnet, daß zwei gleichartige dielektrische Resonatoren vorgesehen sind, zwischen denen ein Freiraum (Abstand A) zur Einführung eines Untersuchungsobjekts angeordnet ist. Die beiden elektrischen Resonatoren sind bezüglich der Resonanzfelder miteinander gekoppelt und bilden zwischen sich im Freiraum einen Bereich maximaler magnetischer Feldstärke. In einem dort eingebrachten Untersuchungsobjekt ergeben sich also sehr stark überhöhte $B_1$-Felder.

Wenn Untersuchungsobjekte untersucht werden sollen, welche aufgrund ihrer Form selbst zur Ausbildung innerer Resonanzmoden neigen (vgl. 7th SMRM 1988, Seite 267) ist es vorteilhaft möglich, daß der dielektrische Resonator in verschiedenen Relativlagen neben einem Untersuchungsobjekt anordbar ist. Durch die geeignete Relativlage des dielektrischen Resonators können die Bereiche resonanzüberhöhter magnetischer Feldstärken im Untersuchungsobjekt gezielt verschoben werden. Insbesondere können Bereiche, welche vorher in einem Minimalbereich der magnetischen Feldstärke lagen, durch Verschieben des dielektrischen Resonators mit nunmehr maximaler Feldstärke beaufschlagt werden. Diese Ausführungsform der Erfindung ermöglicht auch Untersuchungen großvolumiger Untersuchungsobjekte.

Für den dielektrischen Resonator können Festkörper mit hoher Dielektrizitätszahl verwendet werden. Geeignete keramische Materialien sind bekannt aber teuer. Blöcke mit Abmessungen über 20 cm lassen sich kaum herstellen.

Besonders einfach lassen sich dielektrische Resonatoren herstellen, wenn das Dielektrikum des dielektrischen Resonators aus einer Flüssigkeit besteht, welche in einen die Resonatorform vorgegebenden Behälter eingebracht ist. Eine wegen der hohen Dielektrizitätszahl von $\epsilon r = 80$ besonders geeigneten Flüssigkeit ist Wasser ($H_2O$). Weiterhin könnte Ethylenglycol verwendet werden. Ein dielektrischer Resonator mit flüssigem Dielektrikum läßt sich einfach in beliebiger Form und Größe herstellen. Die Füllkörper können beispielsweise aus Plexiglas bestehen. Da die Wandstärke der Füllgehäuse relativ klein sein kann, darf der Einfluß auf die Resonanzfrequenz praktisch vernachlässigt werden.

Probleme können sich mit Flüssigkeitsresonatoren aus $H_2O$ oder Ethylenglycol ($C_2H_6O_2$) dadurch ergeben, daß Spinanregung auch außerhalb des Nutzbereichs, also im Resonator selbst, meistens unvermeidbar ist. Das daraus resultierende starke $^1$H- bzw. $^{13}$C- Signal überlagert sich dem oftmals sehr kleinem Nutzsignal und kann im HF-Vorverstärker zu Dynamikproblemen führen. Ferner muß bei MR Bildgebung, um Rückfaltungsartefakte bei der Bildrekonstruktion zu vermeiden, der Abbildungsbereich der Resonatorgröße angepaßt werden. Der für den Nutzbereich erforderliche kleinere Abbildungsbereich mit entsprechend höherer Bildauflösung kann deshalb nicht genutzt werden.

Die unerwünschten MR-Signale aus Bereichen außerhalb des Nutzraums werden bei Verwendung von Keramik oder schwerem Wasser ($D_2O$) vermieden. Schweres Wasser hat praktisch die gleichen dielektrischen Eigenschaften wie normales Wasser, die MR-Frequenz liegt aber bei gleicher Hauptfeldstärke um den Faktor 6.5 niedriger, stört also bei $^1$H-Messungen nicht.

Für den Fall, daß der dielektrische Resonator zur Protonenentkopplung in $^1$H/$^{13}$C-Doppelresonanzexperimenten dient, sind dielektrische Resonatoren mit der preisgünstigeren Wasserfüllung ohne Probleme verwendbar.

Durch Anregung der Kernspin-Präzession mit einem HF-Drehfeld kann die MR-Signalstärke im Vergleich zur Verwendung eines reinen HF-Wechselfeldes etwa verdoppelt werden. Zur Nutzung dieses Effekts auch für einen dielektrischen Resonator ist deshalb vorgesehen, daß der dielektrische Resonator derart bemessen ist, daß in ihm zwei Resonanzmoden mit einer Phasenverschiebung von vorzugsweise etwa 90° anregbar sind, deren magnetische Felder etwa senkrecht zueinander verlaufen.

Die Erfindung wird anhand der Beschreibung von in der Zeichnung dargestellten vorteilhaften Ausführungsbeispielen näher erläutert.

Figur 1   zeigt die wesentlichen Bestandteile eines erfindungsgemäßen Kernspinresonanzgerätes.

Figur 2   zeigt einen zylindrischen dielektrischen Resonator mit einer zu seiner Zylinderachse orthogonalen Aufnahmebohrung.

Figur 3   zeigt einen zylindrischen dielektrischen Resonator mit zwei Aufnahmebohrungen.

Figur 4   zeigt einen zylindrischen dielektrischen Resonator mit einer koaxialen Aufnahmebohrung und mit räumlich versetzten HF-Anregungspulen.

Figur 5   zeigt zwei koaxial im Abstand zueinander angeordnete zylindrische dielektrische Resonatoren mit einer dazu koaxialen HF-Anregungspule.

Figur 6   zeigt einen neben einem Untersuchungsobjekt verschiebbaren zylindrischen dielektrischen Resonator bei senkrecht zur Zylinderachse verlaufender magnetischen Feldrichtung.

Figur 7   zeigt einen neben einem Untersuchungsobjekt verschiebbaren zylindrischen elektrischen Resonator bei achsparallel zur Zylinderachse verlaufender magnetischer Feldrichtung.

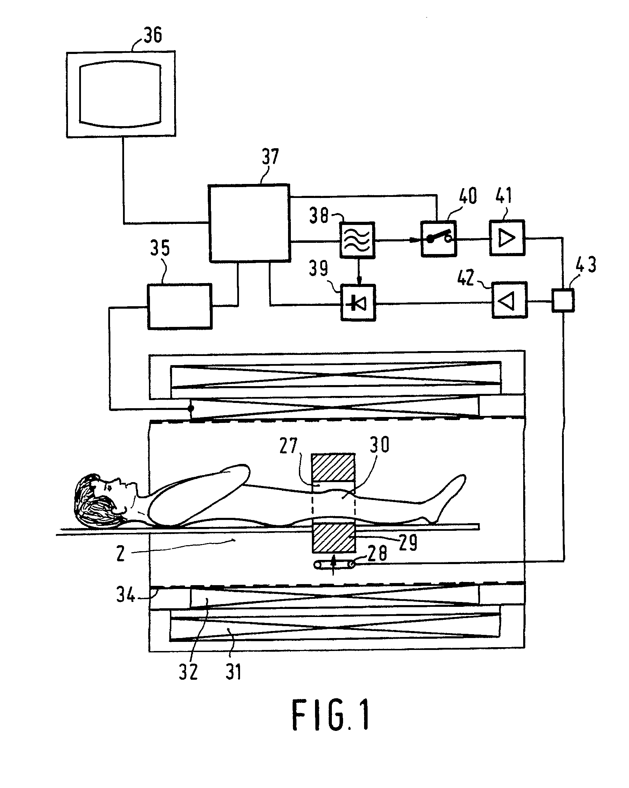

Mit einem in Figur 1 schematisch dargestellten Kernspinuntersuchungsgerät wird im vom Faradayschirm 34 umgebenen Untersuchungsraum 2 mittels der Spulen 31 und 32 ein stationäres Magnetfeld erzeugt. Die Spulen 31 erzeugen ein homogenes Feld, während die Spulen 32 ein Gradientenfeld überlagern.

Im Untersuchungsobjekt 30, im gewählten Beispiel das Knie einer in den Untersuchungsraum 2 gebrachten Person, wird zusätzlich ein Hochfrequenzfeld überlagert, welches mit der als Spule 28 angedeuteten Sendeeinrichtung im Hohlraum 27 des dielektrischen Resonators 29 angeregt wird.

Eine zentrale Steuereinrichtung steuert den Ablauf einer Untersuchung im Untersuchungsobjekt und insbesondere die Energiezufuhr des Generators 35 zu den Gradientenspulen 32 sowie den Monitor 36 zur Bilddarstellung. Ein Hochfrequenzoszillator 38 steuert einerseits den Modulator 40 für den Hochfrequenzgenerator 41, welcher Hochfrequenzenergie über die Weiche 43 zur Sendespule 28 leitet, und andererseits den phasenempfindlichen Gleichrichter 39, welcher die Meßsignale verarbeitet, welche über die Weiche 43 und den Signalverstärker 42 von der Sendespule 28 abgegriffen werden.

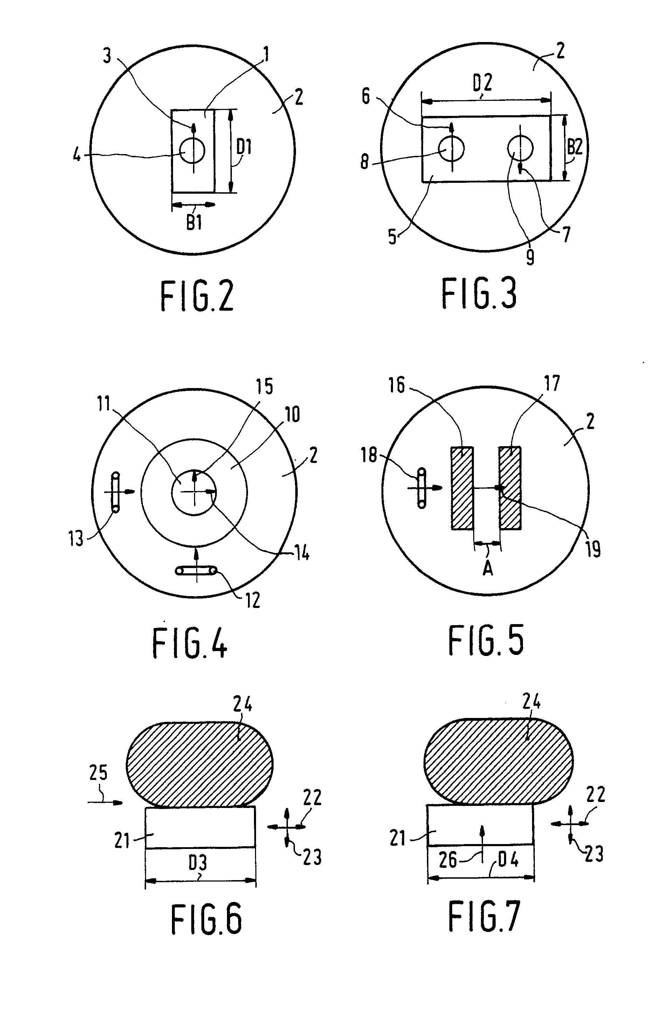

In Figur 2 ist ein zylindrischer dielektrischer Resonator 1 mit dem Durchmesser D1 und der Breite B1 im Untersuchungsraum 2 eines Kernspintomographiegerätes angeordnet. Im Untersuchungsraum 2 herrscht ein senkrecht zur Papierebene, also in z-Richtung gerichtetes magnetisches $B_0$-Gleichfeld. Die Zylinderachse des dielektrischen Resonators verläuft senkrecht zur z-Richtung. Durch nicht dargestellte HF-Spulen wird ein hochfrequentes $B_1$-Feld erzeugt, welches sowohl senkrecht zur Zylinderachse als auch senkrecht zur Richtung des $B_0$-Feldes gerichtet ist (Pfeil 3). Im dielektrischen Resonator 1 entsteht ein in Richtung des anregenden Feldes verlaufendes magnetisches Feld in Form einer Mode bzw. stehenden Welle, deren Maximalwert im Bereich der in z-Richtung verlaufenden Aufnahmebohrung 4 liegt. Ein in die Aufnahmebohrung 4 einzuführendes Untersuchungsobjekt befindet sich dann in einem hohen magnetischen $B_1$-Feld, zu dessen Erzeugung nur eine sehr geringe Sendeleistung erforderlich ist. Die nach dem Abschalten des $B_1$-Feldes vom Zielbereich des Untersuchungsobjekts ausgehenden MR-Signale können mit hohem Signal zu Rauschverhältnis empfangen werden.

In Figur 3 ist im Untersuchungsraum 2 ein zylindrischer elektrischer Resonator 5 mit dem Durchmesser D2 und der Breite B2 angeordnet, in welchem eine Mode höherer Ordnung anregbar ist, so daß zwei Maximalbereiche der magnetischen Feldstärke in den Richtungen und an den Stellen der Pfeile 6 und 7 entstehen. In die parallelen und in z-Richtung verlaufenden Aufnahmebohrungen 8 und 9 können zwei Untersuchungsobjekte eingeführt und gleichzeitig untersucht werden.

In Figur 4 verlaufen die Zylinderachse des dielektrischen Resonators 10 sowie dessen koaxiale Aufnahmebohrung 11 in z-Richtung. Im dielektrischen Resonator 10 werden durch räumlich senkrecht zueinander und jeweils senkrecht zur z-Richtung mit um 90° zeitlich phasenverschobenen gleich großen magnetischen Feldern erregende HF-Spulen 12 und 13 entsprechende magnetische Modenfelder mit den Richtungen 14 und 15 angeregt, welche dann in einem in die Aufnahmebohrung 11 einzuführenden Untersuchungsobjekt ein Drehfeld erzeugen, welches mit der Spinrichtung der anzuregenden Kerne umläuft.

Gemäß Figur 5 sind im Untersuchungsraum 2 gleichartige zylindrische dielektrische Resonatoren 16 und 17 koaxial im Abstand A angeordnet. Zwischen beiden Resonatoren verbleibt ein Freiraum zur Einführung eines Untersuchungsobjekts. Durch die HF-Spule 18 werden in den dielektrischen Resonatoren 16 und 17 magnetische Resonanzfelder in Richtung 19 gebildet, welche sich im Freiraum zwischen den Resonatoren zu einem Bereich stark resonanzüberhöhter Intensität überlagern.

In den Figuren 6 und 7 sind zylindrische dielektrische Resonatoren 20 bzw. 21 mit den Durchmessern D3 bzw. D4 in Richtung der Doppelpfeile 22 und 23 relativ zu einem Untersuchungsobjekt 24 verschiebbar. Die Anordnungen nach den Figuren 6 und 7 unterscheiden sich durch die Richtung 25 bzw. 26 der magnetischen Feldstärke der jeweils angeregten verschiedenartigen Moden. Die Anordnungen nach Fig. 6 und 7 sind insbesondere dann vorteilhaft, wenn großvolumige Untersuchungsobjekte 24 zu untersuchen sind, welche nicht in die Einführungsbohrungen gemäß den Figuren 2 bis 4 und in den Freiraum nach Fig. 5 eingebracht werden können.

Die erforderlichen Abmessungen dielektrischer Resonatoren der in den Figuren dargestellten Art lassen sich aufgrund bekannter physikalischer und mathematischer Gesetzmäßigkeit berechnen. Hinreichend kleine Durchmesser für die dielektrischen Resonatoren, welche auf jeden Fall natürlich kleiner als der verfügbare Innendurchmesser des Untersuchungsraums eines Kernspinuntersuchungsgeräts sein müssen, ergeben sich bei Verwendung von Wasser als Dielektikum bei Werten von $B_0$, die größer als etwa 1,5 Tesla sind.

## Patentansprüche

1. Kernspinuntersuchungsgerät mit einem Magnetsystem (31,32) zum Erzeugen eines stationären Magnetfeldes in einem Untersuchungsraum (2), mit einer Sendeeinrichtung (12,13,18,28) zur Erzeugung eines dem stationären Magnetfeld in einem Untersuchungsobjekt (30) zu überlagernden Hochfrequenzfeldes, mit Mitteln zur Resonanzüberhöhung des im Untersuchungsobjekt (30) wirksamen Hochfrequenzfeldes und mit einer Einrichtung zur Detektierung von im Untersuchungsobjekt (30) erzeugten Magnetresonanzsignalen, dadurch gekennzeichnet, daß mindestens ein dem Untersuchungsobjekt (24) benachbarter dielektrischer Resonator (1,5,10,16,17,20,21) vorgesehen ist, welcher aus einem Dielektrikum mit einer relativen Dielektrizitätszahl $\epsilon_r$ 20 besteht und dessen Abmessungen derart gewählt sind, daß in ihm mittels einer benachbarten Sendeeinrichtung (12,13,18) mindestens eine Resonanzmode mit einer Frequenz anregbar ist, die im Bereich der zu detektierenden Larmorfrequenzen der im Untersuchungsobjekt (24) anzuregenden Kerne, insbesondere Protonen liegt.

2. Anordnung nach Anspruch 1, dadurch gekennzeichnet, daß im dielektrischen Resonator (1,10) eine zentrale Ausnehmung (4,11) im Nullbereich der elektrischen Feldstärke der anregbaren Resonanzmode angeordnet ist.

3. Anordnung nach Anspruch 1, dadurch gekennzeichnet, daß der dielektrische Resonator (5) derart bemessen ist, daß eine Resonanzmode mit zwei Nullbereichen der elektrischen Feldstärke anregbar ist und daß in den Nullbereichen jeweils eine Ausnehmung (8,9) zur Einführung von Untersuchungsobjekten vorgesehen ist.

4. Anordnung nach Anspruch 1, dadurch gekennzeichnet, daß zwei gleichartige dielektrische Resonatoren (16,17) vorgesehen sind, zwischen denen ein Freiraum (Abstand A) zur Einführung eines Untersuchungsobjekts angeordnet ist.

5. Anordnung nach Anspruch 1, dadurch gekennzeichnet, daß der dielektrische Resonator (20,21) in verschiedenen Relativlagen neben einem Untersuchungsobjekt (24) anordbar ist.

6. Anordnung nach einem der Ansprüche 1 bis 5, dadurch gekennzeichnet, daß das Dielektrikum des dielektrischen Resonators (1,5,10,16,17,20,21) aus einer Flüssigkeit besteht, welche in einen die Resonatorform vorgebenden Behälter eingebracht ist.

7. Anordnung nach Anspruch 6, dadurch gekennzeichnet, daß die Flüssigkeit Wasser ($H_2O$) ist.

8. Anordnung nach Anspruch 6, dadurch gekennzeichnet, daß die Flüssigkeit schweres Wasser ($D_2O$) ist.

9. Anordnung nach einem der Ansprüche 1 bis 8, dadurch gekennzeichnet, daß der dielektrische Resonator (10) derart bemessen ist, daß in ihm zwei Resonanzmoden mit einer Phasenverschiebung von vorzugsweise etwa $90^\circ$ anregbar sind, deren magnetischen Felder etwa senkrecht zueinander verlaufen.

10. Dielektrischer Resonator, dadurch gekennzeichnet, daß er zur Verwendung in einem Kernspinuntersuchungsgerät nach einem der Ansprüche 1 bis 9 gestaltet ist.

FIG.1

FIG.2

FIG.3

FIG.4

FIG.5

FIG.6

FIG.7

7